**Europäisches Patentamt**

(19) **European Patent Office**

**Office européen des brevets**

(11) Publication number : **0 126 989 B2**

(12) # NEW EUROPEAN PATENT SPECIFICATION

(45) Date of publication of the new patent specification : **12.02.92 Bulletin 92/07**

(51) Int. Cl.⁵ : **G01L 9/00,** G01L 13/02

(21) Application number : **84104732.7**

(22) Date of filing : **27.04.84**

(54) **Fluid pressure transmitter.**

(30) Priority : **04.05.83 US 491613**

(43) Date of publication of application :
**05.12.84 Bulletin 84/49**

(45) Publication of the grant of the patent :
**19.08.87 Bulletin 87/34**

(45) Mention of the opposition decision :
**12.02.92 Bulletin 92/07**

(84) Designated Contracting States :
**DE FR GB IT**

(56) References cited :
**EP-A- 0 080 186**
**DE-A- 2 718 931**
**US-A- 4 342 231**
**US-A- 4 400 682**
**ELECTRONIC ENGINEERING, vol. 53, no. 659, November 1981, London; E. BOSE "Fluid pressure transducers", page 169**

(56) References cited :
**Patent Abstracts of Japan vol. 4, no. 52, 18 April 1980 page 78E7 & JP-A-55-22819**
**Patent Abstracts of Japan vol. 2, no. 99, 17 august 1978 page 5001E78 & JP-A-53-65089**
**Kyocera prospectus "Ceramic Substrates & Lids"**
**Schott Produktinformation No. 4830, "Glasdurchführungen"**

(73) Proprietor : **HONEYWELL INC.**
**Honeywell Plaza**
**Minneapolis Minnesota 55408 (US)**

(72) Inventor : **Wamstad, David B.**
**2195 North Rosewood Lane**
**Roseville Minnesota 55113 (US)**
Inventor : **Wilda, Douglas W.**
**2200 Grant Mews**
**Ambler Pennsylvania 19002 (US)**

(74) Representative : **Rentzsch, Heinz et al**
**Honeywell Europe S.A. Holding KG Patent- und Lizenzabteilung Kaiserleistrasse 55 W-6050 Offenbach am Main (DE)**

## Description

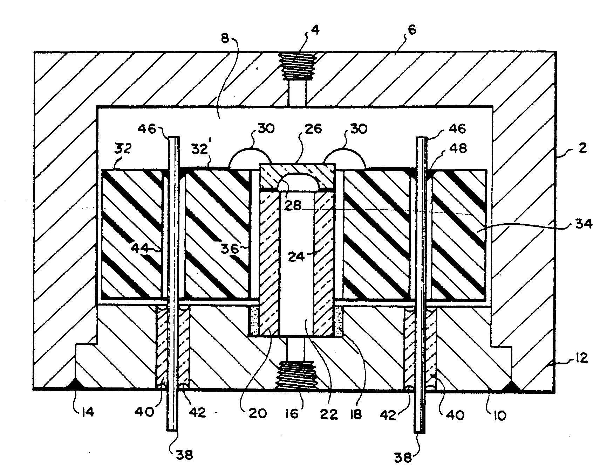

The present invention is directed to fluid pressure transmitters. DE-A1 27 18 931 describes a differential pressure transmitter and shows in Figure 3 a version of the transmitter in which a disk-shaped support for the sensor is carried by a pressure supply tube which projects through one of the walls of the housing. An ion migration shield or Farraday shield is located in front of the sensor within the cavity and is supported by several studs fixed to said wall. This wall furthermore holds within hermetic seals a plurality of electrically conducting wires whose one end extends out of the housing and whose other end by means of a flexible wire is electrically connected to the sensor.

Another known pressure transmitter shown in Electronic Engineering, November 1981, page 169, includes a sensor consisting of a silicon diaphragm supporting four piezoresistors with two located along the diaphragm radius and two others implanted tangentially to the diaphragm radius. As pressure is applied to one side of the diaphragm, two of the resistors increase in value while the other two decrease. The sensor chip together with a sensor support and a thick film circuit are clamped between a base portion of the housing and its cover. O-ring seals are provided between the housing and the sensor on the one side and the ceramic thickfilm circuit and the cover on the other side. The sensor is electrically connected to the thickfilm circuit by resilient wire bonds.

US-A 43 42 231 shows in Figures 2a and 2b the sensor unit of a differential pressure transmitter including a semiconductor sensor supported on a support member carried by the housing. The semiconductor sensor is surrounded by a ring-shaped ceramic substrate, also fixed to the housing but spaced apart from the sensor and its support. This ceramic substrate carries the wiring for the sensor and is electrically connected to the sensor by a plurality of wire-bonded lead wires. A protective cover is positioned in front of the sensor and is also fixed to the housing. Lead wires transmit the electrical signal from the ceramic substrate to the outside of the housing. These lead wires extend through passages in the wall of the housing and said passages are filled with a hermetic seal extending along the entire passage.

An objet of the present invention to provide an improved fluid pressure transmitter assembly, where the seals of the electrical connections of the sensor to the outside of the housing are relieved from mechanical stress caused by changes in temperature of the fluid and the parts inside the housing. A further object of the invention is to minimize the volume of the fluid fill in the housing.

In accomplishing these and other objects, there has been provided the invention, as described in claim 1. Further features and improvements are described in the dependent claims.

A better understanding of the present invention may be had when the following detailed description is read in connection with the accompanying drawing, in which the single figure is a cross section illustration of a fluid pressure transmitter assembly embodying an example of the present invention.

Referring to the single figure in more detail, there is shown a fluid differential pressure transmitter having an outer cup shaped housing 2. A first fluid inlet port 4 is provided in an end wall 6 of the housing 2 to enable a first input pressure to be admitted into an interior volume or cavity 8 defined by the housing 2. A cover 10 for an open end 12 of the housing 2 is attached thereto by any suitable means providing a fluid-tight seal, e.g., an electron beam weld 14. A second fluid inlet port 16 is provided in the cover 10 to allow the admission of a second input fluid pressure into the housing 2. The cover 10 is provided with a circular recess 18 coaxial with the second fluid inlet port 16. A hollow support tube 24 has a first end 20 coaxially mounted within the recess 18 and is bonded to the adjacent side wall of the recess 18 by any suitable means, e.g. an adhesive, to provide a fluid-tight seal thereto. A fluid conduit 22 within the tube 24 is aligned with the second fluid port 16 to conduct a fluid admitted by the second port 16.

A second end of the tube 24 is used to support a pressure sensor in the form of a diaphragm 26 which is secured at its peripheral edge 28 to the second end of the tube 24. The attachment of the diaphragm 26 to the tube 24 is arranged to provide a fluid-tight seal between the diaphragm 26 and the tube 24. The diaphragm 26 has a pressure sensitive coating thereon which may be in the form of piezo-resistive elements, in a manner well-known in the art. These diaphragm elements are attached to one end of respective ones of a plurality of flexible wires 30 which provide electrical connections thereto. The other ends of the wires 30 are connected to respective ones of electrically conductive paths 32' supported on a first end surface 32 of a spacer 34 located within the interior volume 8 defined by the housing. The spacer 34 is preferably in the form of a cylindrical element coaxial with the tube 24 and having an axial aperture 36 spaced from the tube 24.

A plurality of electrically conductive and relatively rigid electrode wires 38 are arranged to pass through holes 40 in the cover 10. Hermetic seals 42 are located between the wires 38 and the surfaces of the cover 10 surrounding the holes 40 to provide fluid-tight connections thereto. The wires 38 extend into the housing cavity 8 and pass through respective ones of a plurality of bores 44 in the spacer 34 which coaxially surround each of the corresponding ones of the electrode wires 38 while being spaced therefrom. The free ends 46 of the electrode wires 38 within the housing 2 are rigidly attached to the first end surface 32 of the spacer 34 by any suitable means to provide mechanical and electrical connections 48 thereto, e.g., or soldering. The connections 48 are arranged to provide a support junction for the spacer 34 and to provide a current path between the electrode wires 38 and the aforesaid electrically conducting paths 32′ on the end surface 32 of the spacer 34 which, in turn, as previously described, are connected to the wires 30 leading to the diaphragm pressure sensor 26.

The spacer 34 is arranged to be a free floating element within the cavity 8 of the housing 2 and is, accordingly, spaced from the interior walls of the housing 6, the cover 10, the electrode wires 38, the support tube 24 and the diaphragm 26. Thus, the spacer 34 is suspended from the connections 48 to the electrode wires 38 whereby temperature changes in the environment of the pressure transmitter, which can produce physical changes in the spacer 34 based on the coefficient of temperature expansion of the spacer 34, do not affect the hermetic seals 40, i.e., the hermetic seals 40 are not stressed by temperature induced expansions and contractions of the spacer 34. The spacer 34 is used to reduce the volume within the housing 2 to minimize the amount of a fill fluid (not shown) needed for transmitting the first input pressure to one side of the sensor diaphragm 26. A first fill fluid would be arranged to fill the cavity 8 within the housing 2 while a second fill fluid (not shown) would be arranged to fill the fluid conduit 22 within the tube 24 to transmit a second input pressure to the other side of the sensor diaphragm 26. Concurrently, the spacer 34 provides a support for the electrical connections 32′ between the flexible wires 30 and the electrode wires 38. The illustrated size relative and shape of the spacer 34 is only intended to provide an example of the present invention since the size and shape thereof may be modified to conform the spacer 34 to the operating requirements of the transmitter.

Accordingly, it may be seen that there has been provided, in accordance with the present invention an improved fluid pressure transmitter assembly.

## Claims

1. A pressure transmitter comprising:
a) a housing (2, 6, 10) for being filled with a fill fluid and having at least one pressure inlet port (4, 16);
b) pressure sensing means (24, 26) mounted within said housing and including a pressure sensor in the form of a diaphragm (26) and a mounting tube (24) for said sensor (26);
c) electrically conducting wires (38) held in a wall (10) of said housing (2, 6, 10) by hermetic seals (42) with one end of said wires extending out of said housing and the other end being electrically connected to said pressure sensor (26);
d) a spacer (34) provided within the cavity (8) of said housing for minimizing the free volume therein;
e) bores (44) extending through said spacer (34) in the direction of said wires (38);
f) said wires (38) extending freely through said bores (44) and being mechanically fixed to said spacer (34) at the end of said bores remote from said wall (10), such that
g) said spacer (34) is suspended as a free floating body within said housing (2, 6, 10) and is spaced from the interior walls of said housing and from said sensing means (24, 26).

2. The transmitter according to claim 1, **characterized** electrical connection means (30, 32′) electrically connected to said wires (38) and supported on that surface (32) of said spacer (34).

3. The transmitter according to claim 2, **characterized** in that the connection means (30, 32′) includes at least one electrical conductor (32′) mounted on said surface (32) of the spacer (34) and at least one flexible wire (30) connecting said conductor (32′) to said sensor (26).

4. The transmitter according to claim 3, **characterized in that** said spacer (34) is coaxial with said tube (24) while being spaced therefrom.

5. The transmitter according to claim 4, **characterized in that**
a) pressure supply ports (4, 16) are provided in opposite wall portions (6, 10) of the housing (2, 6, 10);
b) the sensor mounting tube (24) is positioned with one end (20) in a recess (18) of one of said wall portions (10) and with its internal fluid conduit (22) communicating with one of said ports (16);
c) the sensor mounting tube (24) is sealed within said recess (18);
d) the sensor (26) is fixed to the free end of said tube (24) closing said fluid conduit (22);
e) the spacer (34) is ring-shaped and surrounds said tube (24) without touching said tube or parts of the housing;
f) said bores (44) are open at that side of the spacer (34) which faces said one wall portion (10).

## Patentansprüche

1. Druckgeber mit
a) einem mit einer Füllflüssigkeit zu füllenden und wenigstens einen Druckeinlaß (4, 16) aufweisenden Gehäuse (2, 6, 10);
b) einer im Gehäuse gehaltenen Druckmeßeinrichtung (24, 26), welche einen Druckfühler in Form einer Membran (26) sowie ein Halterohr (24) für den Fühler (26) aufweist;
c) in einer Wand (10) des Gehäuses (2, 6, 10) durch hermetische Abdichtungen (42) gehaltenen elektrisch leitenden Drähten (38), wobei ein Ende der Drähte aus dem Gehäuse herausragt und das andere Ende elektrisch mit dem Druckfühler (26) verbunden ist;

d) einem im Innenraum (8) des Gehäuses befindlichen Füllstück (34) zur Minimierung des freien Volumens des Innenraums;

e) sich in Richtung der Drähte (38) durch das Füllstück (34) hindurch erstreckenden Löchern (44);

f) wobei die Drähte (38) frei durch die Löcher (44) hindruchragen und an dem der genannten Wand (10) fernen Ende der Löcher am Füllstück (34) derart befestigt sind; daß

g) das Füllstück (34) als freischwebender Körper im Gehäuse (2, 6, 10) im Abstand von den Innenwänden des Gehäuses und von der Meßeinrichtung (24, 26) gehalten ist.

2. Druckgeber nach Anspruch 1, **gekennzeichnet durch** elektrisch mit den Drähten (38) verbundene und von der Oberfläche (32) des Füllstücks (34) getragene elektrische Anschlußmittel (30, 32').

3. Druckgeber nach Anspruch 2, **dadurch gekennzeichnet**, daß die Anschlußmittel (30, 32') wenigstens einen auf der genannten Oberfläche (32) angebrachten elektrischen Leiter (32') sowie wenigstens einen diesen Leiter (32') mit dem Fühler (26) verbindenden flexiblen Draht (30) aufweisen.

4. Druckgeber nach Anspruch 3, **dadurch gekennzeichnet**, daß das Füllstück (34) koaxial zum Halterohr (24) aber im Abstand hiervon angeordnet ist.

5. Druckgeber nach Anspruch 4, **dadurch gekennzeichnet**, daß

a) Druckeinlässe (4, 16) in gegenüberliegenden Wandteilen (6, 10) des Gehäuses (2, 6, 10) vorgesehen sind;

b) das Fühlertragrohr (24) sich mit einem Ende in einer Vertiefung (18) des einen Wandteils (10) befindet und mit seinem internen Hohlraum (22) mit einem (16) der Einlässe in Verbindung steht;

c) das Fühlertragrohr (24) in der Vertiefung (18) abgedichtet ist;

d) der Fühler (26) am freien Ende des Tragrohrs (24) befestigt ist und den Hohlraum (22) verschließt;

e) das Füllstück (34) ringförmig ausgebildet ist und das Tragrohr (24) umgibt, ohne dabei das Tragrohr oder Teile des Gehäuses zu berühren;

f) die Löcher (44) auf der dem genannten einen Wandteil (10) zugewandten Seite des Füllstücks (34) offen sind.

**Revendications**

1. Transducteur de pression comprenant :
a) un boîtier (2, 6, 10) destiné à être rempli par un fluide de remplissage et ayant au moins un accès d'entrée de pression (4, 16) ;

b) un moyen de détection de pression (24, 26) monté dans ledit boîtier et comprenant un détecteur de pression ayant la forme d'un diaphragme (26) et un tube de montage (24) pour ledit détecteur (26) ;

c) des fils électriquement conducteurs (38) maintenus dans une paroi (10) dudit boîtier (2, 6, 10) au aryen de joints d'étanchéité hermétiques (42), une extrémité desdits fils s'étendant hors dudit boîtier et l'autre extrémité étant raccordée électriquement audit détecteur de pression (26) ;

d) une cale (34) disposée dans la cavité (8) dudit boîtier pour minimiser le volume libre qui y est contenu ;

e) des alésages (44) s'étendant à travers ladite cale (34) dans la direction desdits fils (38) ;

f) lesdits fils (38) s'étendant librement à travers lesdits alésages (44) et étant mécaniquement fixés à ladite cale (34) à l'extrémité desdits alésages éloignés de ladite paroi (10), de telle sorte que

g) ladite cale (34) est suspendue comme un corps flottant librement dans ledit boîtier (2, 6, 10) et est espacée des parois intérieures dudit boîtier et dudit moyen de détection (24, 26).

2. Le transducteur selon la revendication 1, caractérisé par des moyens de connexions électriques (30, 32') reliés électriquement auxdits fils (38) et supportés sur la surface (32) de ladite cale (34).

3. Le transducteur selon la revendication 2, caractérisé en ce que les moyens de connexions électriques (30, 32') comportent au moins un conducteur électrique (32') monté sur ladite surface (32) de la cale (34) et au moins un fil flexible (30) raccordant ledit conducteur (32') audit détecteur (26).

4. Le transducteur selon la revendication 3, caractérisé en ce que ladite cale (34) est coaxiale avec ledit tube (24) tout en en étant espacée.

5. Le transducteur selon la revendication 4, caractérisé en ce que

a) les accès de fourniture de pression (4, 16) sont prévus dans des parties de parois opposées (6, 10) du boîtier (2, 6, 10) ;

b) le tube de montage de détecteur (24) est disposé avec une extrémité (20) dans un évidement (18) de l'une des parties de parois (10) et avec sa conduite de fluide interne (22) en communication avec l'un desdits accès (16) ;

c) le tube de montage de détecteur (24) est disposé de manière étanche dans ledit évidement (18) ;

d) le détecteur (26) est fixé à l'extrémité libre dudit tube (24) fermant ladite conduite de fluide (22) ;

e) la cale (24) a une forme d'anneau et entoure ledit tube (24) sans toucher ledit tube ou des parties du boîtier ;

f) lesdits alésages (44) sont ouverts du côté de la cale (34) qui fait face à ladite première partie de paroi (10).